# FASCICULE DE BREVET EUROPEEN

(11) **EP 3 499 254 B1**
(45) Date de publication et mention de la délivrance du brevet: **05.08.2020**
(21) Numéro de dépôt: 18212424.8
(22) Date de dépôt: 13.12.2018
(51) Int. Cl.: G01K 3/00, G01R 31/14, G01K 7/00, G01K 7/16

(54) **SURVEILLANCE D'UN DÉFAUT DANS UN EQUIPEMENT ÉLECTRIQUE**
ÜBERWACHUNG EINER STÖRUNG IN EINER ELEKTRISCHEN AUSRÜSTUNG
MONITORING OF A FAULT IN ELECTRICAL EQUIPMENT

(30) Priorité: 14.12.2017 FR 1701307
(43) Date de publication de la demande: 19.06.2019
(73) Titulaire: Thales, 92400 Courbevoie (FR)
(72) Inventeur: ABDESSELAM, Francis, 78401 CHATOU (FR); DEVAUTOUR, Joël, 78401 CHATOU (FR)
(74) Mandataire: Collet, Alain

(56) Documents cités:
- US-A1- 2004 056 321
- US-A1- 2007 215 973

## Description

L'invention concerne la surveillance d'un équipement électrique. L'apparition d'un défaut dans un équipement électrique peut entrainer des conséquences critiques qu'il convient de surveiller pour, le cas échéant, prendre des mesures afin d'éviter les conséquences critiques.

L'invention s'intéresse à deux causes principales de défaut susceptibles d'intervenir dans un équipement électrique : l'apparition d'arcs électriques entre deux potentiels différents pouvant entrainer la rupture d'éléments d'isolation électrique et l'apparition d'une surchauffe pouvant entrainer un emballement thermique.

L'apparition de surchauffe peut être détectée par un capteur de température. Il peut s'agir de résistance à coefficient de température positif ou négatif. Le capteur de température est relié à un circuit pouvant détecter le dépassement d'une température maximale à ne pas dépasser. En cas de dépassement, une alarme peut être activée. Il également possible de couper l'alimentation électrique de tout ou partie de l'équipement afin de supprimer l'origine de la surchauffe.

La détection d'un arc peut être réalisée par une surveillance d'un courant circulant dans l'équipement et notamment par la détection de composantes hautes fréquences apparaissant dans le courant. Comme pour la surchauffe, la détection d'un arc peut être couplée à une alarme ou à la coupure de l'alimentation électrique de l'équipement.

Des documents pertinents de l'état de la technique sont US 2004/056321 A1 et US 2007/215973 A1.

L'invention propose un moyen simple permettant la surveillance de l'apparition d'arcs électrique et éventuellement l'apparition d'une surchauffe.

A cet effet, l'invention a pour objet un équipement électrique comprenant :
- deux circuits isolés électriquement,
- un écran en forme de film disposé entre les deux circuits, l'écran comprenant un substrat et un filament conducteur disposé sur le substrat,
- un module configuré pour faire circuler un courant dans le filament conducteur et pour détecter une rupture du filament conducteur par arrêt de la circulation du courant.

Le module est avantageusement configuré pour ouvrir un contacteur si un courant circulant dans le filament est nul. La détection de la rupture du filament peut se faire en vérifiant si un courant circulant dans le filament passe en dessous d'un seuil donné.

Le contacteur peut assurer l'alimentation électrique d'au moins un des circuits.

Dans une configuration particulière de l'invention, un premier des deux circuits possède une surface frontale, un second des deux circuits possède une surface frontale, les deux surfaces frontales se faisant face. Une surface commune correspondant à la plus grande partie en regard des deux surfaces frontales est définie. Les dimensions de la surface de l'écran sont supérieures à celles de la surface commune.

Le filament est avantageusement formé dans un matériau résistif à coefficient de température non nul. Ainsi, une mesure de résistance du filament permet la détection d'un défaut en cas de surchauffe d'un des circuits.

Le filament serpente avantageusement de façon régulière sur la surface du substrat. Ainsi tout défaut, même local, peut être détecté.

Avantageusement, le filament est formé de deux conducteurs électriques séparés. Ces deux conducteurs permettent notamment une redondance en cas de défaut d'un des filaments.

Avantageusement, les deux conducteurs électriques recouvrent sensiblement la totalité d'une surface utile de l'écran. La surface utile est la plus petite surface de contour convexe de l'écran entourant le filament. Ainsi tout défaut apparaissant dans l'un des circuits en regard de la surface utile peut être détecté.

Avantageusement, les deux conducteurs électriques sont disposés sur le substrat de façon à limiter la surface d'une spire formée par le filament. Cette configuration permet de limiter un éventuel effet d'antenne généré par le filament.

Avantageusement, l'écran forme un écran électrostatique entre les deux circuits.

Dans une configuration particulière de l'invention, chacun des circuits est un enroulement, l'équipement formant un transformateur.

Dans une configuration ou l'équipement forme un transformateur, l'écran est avantageusement disposé parallèlement à une direction principale d'un champ magnétique couplant les deux enroulements. Ceci limite un effet de couplage électromagnétique du filament avec les enroulements.

L'invention sera mieux comprise et d'autres avantages apparaîtront à la lecture de la description détaillée d'un mode de réalisation donné à titre d'exemple, description illustrée par le dessin joint dans lequel :
la figure 1 représente schématiquement un équipement conforme à l'invention ;
les figures 2 et 3 représentent deux variantes de réalisation de filaments équipant un écran interposé entre deux circuits électriques de l'équipement de la figure 1 ;
les figures 2a et 3a représentent chacune un schéma équivalent des filaments représentés sur les figures 2 et 3 ;
les figures 4 et 5 représentent de façon séparée deux conducteurs formant le filament représenté sur les figures 3 et 3a ;
les figures 6 et 7 représentent deux variantes de raccordement de deux conducteurs formant le filament de la figure 3 ;
les figures 6a et 7a représentent chacune un schéma équivalent des variantes de raccordement des figures 6 et 7 ;
la figure 8 représente un exemple de module raccordé à l'écran ;
la figure 9 représente un transformateur mettant en œuvre l'invention ;

Par souci de clarté, les mêmes éléments porteront les mêmes repères dans les différentes figures.

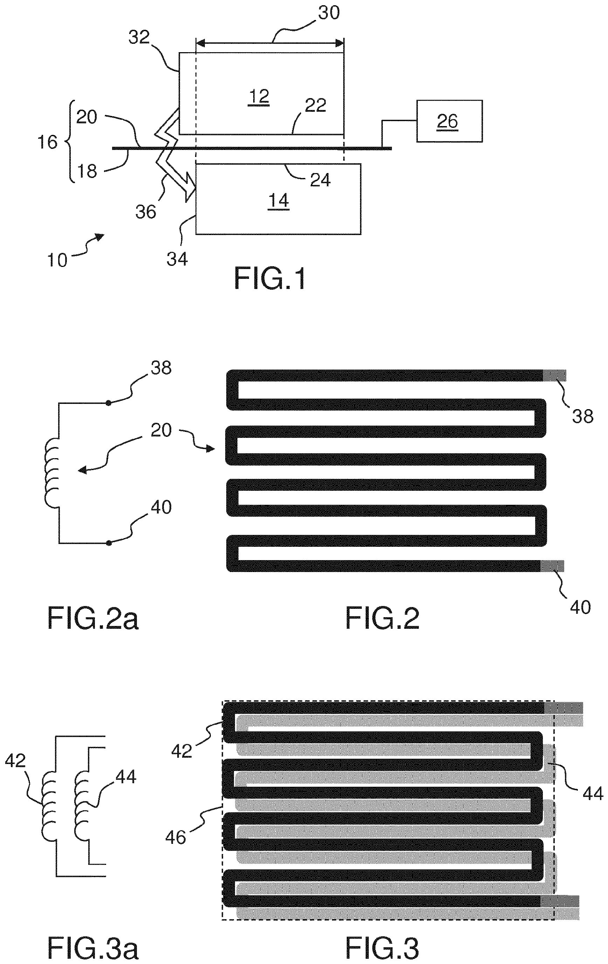

La figure 1 représente un exemple d'équipement électrique 10 comprenant deux circuits 12 et 14 isolés électriquement. Pour la mise en œuvre de l'invention, les deux circuits 12 et 14 peuvent assurer tout type de fonction et peuvent comprendre tout type de composant électrique ou électronique. L'un des deux circuits peut être une simple masse électrique. L'invention trouve son utilité dès qu'un risque de surchauffe est susceptible de se produire dans au moins l'un des deux circuits et/ou qu'un risque d'arc électrique est susceptible de se produire entre les deux circuits.

Pour la détection d'un défaut, l'équipement électrique 10 comprend un écran 16 disposé entre les deux circuits 12 et 14. L'écran 16 comprend un substrat isolant 18 et un filament conducteur 20 disposé sur le substrat 18. Les deux circuits 12 et 14 possèdent chacun une surface dite frontale, 22 pour le circuit 12 et 24 pour le circuit 14. Les deux surfaces frontales 22 et 24 se font face. L'écran 16 a la forme d'un film venant s'interposer entre les deux surfaces frontales 22 et 24. L'équipement électrique 10 comprend aussi un module 26 configuré pour faire circuler un courant dans le filament 20 et pour surveiller ce courant.

On verra plus loin comment la surveillance du courant permet de détecter une surchauffe intervenant dans l'un des circuits 12 ou 14 ou un arc se produisant entre les deux circuits 12 et 14.

Les deux surfaces frontales 22 et 24 peuvent avoir des dimensions différentes. On définit une surface commune 30 correspondant à la plus grande partie en regard des deux surfaces 22 et 24. Les dimensions de la surface de l'écran 16 peuvent être inférieures à celles de la surface commune 30. L'écran 16 est alors disposé en regard de zones des circuits 12 et 14 où le risque d'échauffement excessif et/ou d'arc électrique existe. Cependant, concernant le risque d'arc électrique, ceux-ci peuvent se produire entre d'autres faces des deux circuits 12 et 14 que les faces frontales 22 et 24. Ce risque est schématisé sur la figure 1 où un arc 36 se produit entre une face latérale 32 du circuit 12 et une face latérale 34 du circuit 14. Avantageusement, les dimensions de la surface de l'écran 16 sont supérieures à celles de la surface commune 30 afin de permettre la détection d'un arc se produisant entre les deux surfaces frontales 22 et 24 et également entre deux autres surfaces des deux circuits 12 et 14. En pratique lorsqu'un arc 36 survient entre les deux circuits, l'écran 16 est percé.

La figure 2 représente une première variante de réalisation du filament 20 porté par le substrat 18 par exemple formé d'un film souple par exemple à base de polyimide ou de polyétheréthercétone (PEEK).

Le filament 20 est par exemple réalisé dans un matériau résistif à coefficient de température non nul. Ce coefficient peut être positif ou négatif. Ainsi en cas de surchauffe de l'un des circuits 12 ou 14, la surchauffe est transmise au filament 20 par conduction et sa résistance augmente. En surveillant le courant circulant dans le filament 20, le module 26 peut détecter la surchauffe.

Par ailleurs, un arc électrique se produisant entre les deux circuits 12 et 14 tendra à traverser l'écran 16 en le perforant. La détection de l'arc peut se faire si le filament 20 est coupé par la perforation de l'écran 16. Des essais en interne ont montré qu'en cas d'arc, des trous de plusieurs cm² sont observés dans l'écran 16. Le filament 20 est donc disposé sur le substrat 18 là où un risque d'arc existe.

Avantageusement, le filament 20 serpente de façon régulière sur une face du substrat 18. Ainsi, la détection d'un défaut tel qu'un arc ou éventuellement une surchauffe peut se faire sur toute la surface de l'écran 16. La largeur du filament 20 et sa répartition sur le substrat 18 est définie de façon à ce qu'un arc puisse couper le filament 20. En d'autres termes, le filament 20 doit posséder une largeur suffisamment faible pour pouvoir être coupé par un arc. Des essais en interne ont montré que lors de l'apparition d'un arc, le film 16 est perforé sur au moins 1 cm². Avec une largeur de filament 20 inférieure à 5mm et une distance entre deux brins voisins de filament également inférieure à 5mm, la rupture du filament est quasi certaine lorsqu'un arc apparait. La figure 2a représente un schéma équivalent du filament 20 de la figure 2. Il s'agit ici d'un composant résistif possédant deux bornes de raccordement 38 et 40 reliées au module 26.

La répartition régulière du filament 20 sur le substrat 18 permet aussi à l'écran 16 de remplir une fonction d'écran électrostatique entre les deux circuits 12 et 14.

La figure 3 représente une seconde variante de réalisation du filament 20 porté par le substrat 18. Le filament 20 est ici formé des deux conducteurs électriques 42 et 44 pouvant être tous deux raccordés au module 26. Il est ainsi possible d'assurer une redondance du filament 20. La figure 3a représente un schéma équivalent des deux conducteurs 42 et 44. Il est bien sûr possible de former le filament 20 avec plus de deux conducteurs distincts.

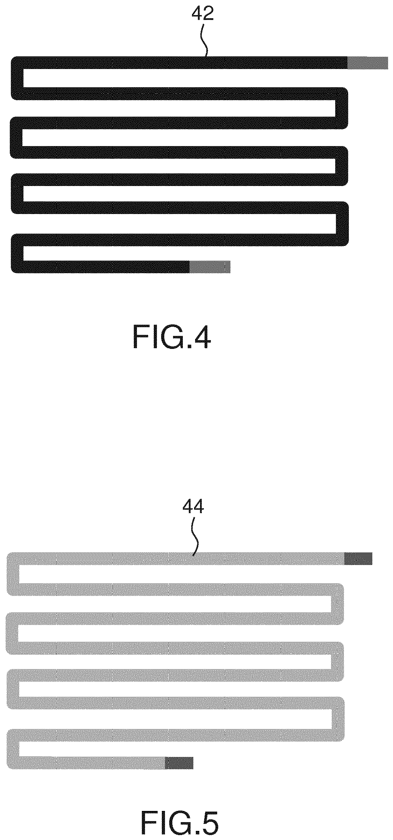

Les figures 4 et 5 représentent de façon séparée les deux conducteurs 42 et 44 qu'il est possible de disposer chacun sur une des faces du substrat 18. Les deux conducteurs sont avantageusement dimensionnés pour qu'en se superposant, chacun sur sa face, ils recouvrent à eux deux sensiblement la totalité d'une surface utile 46 de l'écran 16 représentée en trait pointillé sur le figure 3. La surface utile 46 est la plus petite surface de contour convexe de l'écran 16 entourant le ou les conducteurs 42 et 44 formant le filament 20. Ainsi dès qu'un arc traverse l'écran 16 en perforant la surface utile 46, l'un au moins des deux conducteurs 42 ou 44 est endommagé, ce qui modifiera sa résistance. En surveillant le courant circulant dans les conducteurs 42 ou 44, il est alors possible de détecter un arc en comparant le courant circulant dans les conducteurs 42 et 44 à un seuil prédéterminé. En dessous de ce seuil, on peut considérer qu'un arc s'est produit. Dans la plupart des cas d'apparition d'arc, l'un au moins des deux conducteurs 42 ou 44 est sectionné.

Plus précisément, la surface utile 46 est une surface fermée de l'écran 16 dans laquelle la détection des défauts peut se faire. Le substrat 18 peut être plus grand que la surface utile 46 notamment afin d'assurer l'isolement électrique des deux conducteurs 42 et 44 l'un par rapport à l'autre et afin d'assurer les connexions électriques des conducteurs 42 et 44 au module 26. Pour recouvrir la totalité de la surface utile 46, chacun des deux conducteurs 42 et 44 occupe au moins la moitié de la surface utile 46. Les deux conducteurs 42 et 44 sont formés par des pistes imprimées sur le substrat 18. Les deux conducteurs 42 et 44 ont avantageusement une largeur de piste sensiblement constante sur toute leur longueur. Les conducteurs 42 et 44 peuvent se chevaucher.

Le fait que les conducteurs 42 ou 44 occupent la totalité de la surface utile 46 permet également d'améliorer la possibilité de détection d'une surchauffe.

Pour remplir la fonction d'écran électrostatique, il n'est pas nécessaire que le filament 20, formé ici des deux conducteurs 42 et 44, recouvrent la totalité d'une surface utile 46 de l'écran 16. Des zones non recouvertes peuvent subsister. La disposition des conducteurs 42 et 44 est définie en fonction de la fréquence maximale que peut protéger l'écran 16 dans sa fonction d'écrantage électrostatique.

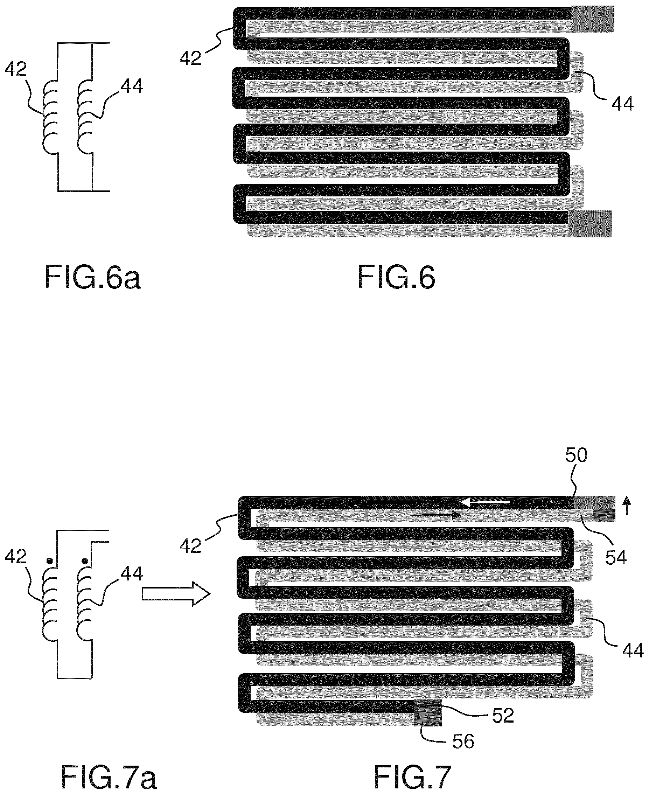

La figure 6 représente une première variante de raccordement de deux conducteurs 42 et 44. Dans cette variante, les deux conducteurs 42 et 44 sont raccordés en parallèle. La figure 6a représente un schéma équivalent de la variante de la figure 6. Le raccordement en parallèle des deux conducteurs 42 et 44 permet d'assurer la redondance dans le fonctionnement du filament 20.

La figure 7 représente une seconde variante de raccordement de deux conducteurs 42 et 44 dans laquelle les deux conducteurs 42 et 44 sont raccordés en série. La figure 7a représente un schéma équivalent de la variante de la figure 7. Les deux conducteurs électriques 42 et 44 sont disposés sur le substrat 18 de façon à limiter la surface d'une spire formée par le filament 20. Autrement dit, la disposition des conducteurs 42 et 44 sur le substrat 18 permet de limiter l'inductance du filament 20. Plus précisément, le conducteur 42 s'étend entre deux extrémités 50 et 52. De même, le conducteur 44 s'étend entre deux extrémités 54 et 56. La connexion en série des conducteurs 42 et 44 est réalisée en connectant les extrémités 52 et 56. Par ailleurs, les extrémités 50 et 54 sont disposées au plus près l'une de l'autre pour former les bornes du filament 20 connectées au module 26. Entre leurs extrémités respectives, les deux conducteurs 42 et 44 serpentent en suivant la même forme l'un sur une des faces du substrat 18 et l'autre sur l'autre face. Un léger décalage est réalisé entre les deux conducteurs 42 et 44 afin de recouvrir la totalité d'une surface utile 46. Il est possible de configurer les conducteurs 42 et 44 afin qu'ils se recouvrent même en partie tout au long de leur cheminement entre leurs extrémités respectives.

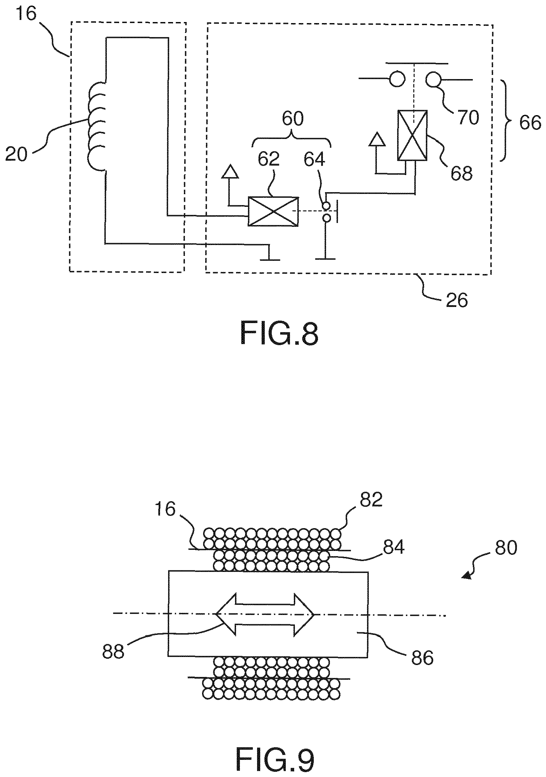

La figure 8 représente un exemple de module 26 raccordé à l'écran 16. Le filament 20 est alimenté en tension continue. Le module 26 comprend un relais 60 possédant une bobine 62 apte à déclencher un contacteur 64. Le filament 20 et la bobine 62 sont raccordés en série. Lorsqu'un courant nominal circule dans le filament 20 et dans la bobine 62, le contacteur 64 est dans un premier état, par exemple fermé. Lorsque l'intensité du courant passe en dessous d'un seuil prédéterminé, le contacteur 64 passe dans un second état, par exemple ouvert. Les deux états du contacteur peuvent bien entendu être inversés. La réduction du courant peut être due à une rupture du filament 20, par exemple lorsqu'un arc électrique traverse l'écran 16. Le seuil prédéterminé est représentatif d'une rupture du filament 20. En pratique, le seuil prédéterminé est fixé à une valeur d'intensité suffisamment basse pour qu'en fonctionnement nominal, l'intensité du courant circulant dans le filament soit toujours supérieure à la valeur donnée.

La réduction du courant peut également être due à une augmentation excessive de température de l'écran 16. Comme indiqué précédemment, le filament 20 peut être formé au moyen d'un conducteur résistif à coefficient de température positif. Lorsque la température de l'écran 16 augmente, la résistance du filament 20 augmente et le courant qui y circule diminue, ce qui peut provoquer une alarme ou un changement d'état du contacteur 64. Le relais 60 est alors calibré de façon à changer d'état lorsque l'intensité du courant circulant dans le filament devient inférieure à un second seuil prédéterminé supérieur au seuil de détection de rupture du filament 20. Ainsi en cas de surchauffe, il est possible soit de mettre en œuvre une alarme soit de faire basculer le relais 60.

Le module 26 peut comprendre un second relais 66 disposé en aval du premier relais. Plus précisément, le contacteur 64 permet d'alimenter une bobine 68 du second relais 66 qui à son tour fait changer l'état d'un contacteur 70 du second relais 66. La mise en place du second relais 66 permet, en cas de besoin, de mettre en place un contacteur 70 autorisant le passage d'un courant nominal plus important que pour le contacteur 64.

Le contacteur 64 ou, lorsqu'il est présent, le contacteur 70 peuvent être placé dans un circuit d'alimentation de l'un des circuits 12 ou 14 ou dans un circuit d'alimentation des deux circuits 12 et 14. En cas de défaut augmentant la résistance du filament 20, notamment lorsque le filament 20 est coupé, l'alimentation du circuit concerné est interrompue, ce qui permet de supprimer la cause du défaut. En cas d'arc électrique entre les deux circuits 12 et 14, détecté par coupure du filament 20, l'alimentation d'un des circuits est immédiatement coupée. Alternativement, le contacteur 64 peut déclencher une alarme permettant d'autres types d'opérations sur l'un des circuits 12 ou 14.

D'autres réalisations du module 26 sont possibles. Il est par exemple possible d'y placer un comparateur comparant le courant circulant dans le filament 20 ou la tension présente à ses bornes à une référence, voire à plusieurs courants ou tension de référence. La sortie du comparateur délivre alors une information sur la présence ou non d'un défaut. Comme précédemment, cette information peut être utilisée pour couper l'alimentation d'un des circuits 12 ou 14, voire des deux.

La figure 9 représente un transformateur 80 mettant en œuvre l'invention. Le transformateur 80 comprend deux enroulements 82 et 84 isolés électriquement et couplés magnétiquement. Chacun des enroulements 82 et 84 forme un exemple de réalisation d'un des circuits 12 et 14 décrits précédemment. Les enroulements 82 et 84 sont séparés par l'écran 16 permettant ainsi de détecter une surchauffe dans l'un des enroulements ou un arc électrique se produisant entre les deux enroulements 82 et 84.

Dans l'exemple représenté, les deux enroulements 82 et 84 sont enroulés autour d'un noyau magnétique 86. Les deux enroulements 82 et 84 sont par exemple enroulés concentriquement autour du noyau magnétique 86. L'écran 16 entoure l'enroulement 84 et est disposé à l'intérieur de l'enroulement 82. Dans cette configuration concentrique des deux enroulements 82 et 84, l'écran 16 est disposé parallèlement à une direction principale 88 du champ magnétique couplant les deux enroulements 82 et 84. Ainsi, même si l'écran 16 forme une boucle de courant, celle-ci n'est pas, ou est très faiblement, traversée par le champ magnétique du transformateur 80.

## Revendications

1. Equipement électrique comprenant :
• deux circuits (12, 14) isolés électriquement,
• un écran (16) en forme de film disposé entre les deux circuits (12, 14), l'écran (16) comprenant un substrat (18) et un filament conducteur (20) disposé sur le substrat (18),
• un module (26) configuré pour faire circuler un courant dans le filament conducteur (20) et pour détecter une rupture du filament conducteur (20) par arrêt de la circulation du courant.

2. Equipement électrique selon la revendication 1, dans lequel le module (26) est configuré pour ouvrir un contacteur (64, 70) si un courant circulant dans le filament (20) est nul.

3. Equipement électrique selon la revendication 2, dans lequel le contacteur (64, 70) assure l'alimentation électrique d'au moins un des circuits (12, 14).

4. Equipement électrique selon l'une des revendications 2 ou 3, dans lequel le module (26) est configuré pour ouvrir le contacteur (64, 70) si un courant circulant dans le filament (20) passe en dessous d'un seuil donné.

5. Equipement électrique selon l'une des revendications précédentes, dans lequel un premier (12) des deux circuits possède une surface frontale (22), un second (14) des deux circuits possède une surface frontale (24), les deux surfaces frontales (22, 24) se faisant face, dans lequel est définie une surface commune (30) correspondant à la plus grande partie en regard des deux surfaces frontales (22, 24), et dans lequel les dimensions de la surface de l'écran (16) sont supérieures à celles de la surface commune (30).

6. Equipement électrique selon l'une des revendications précédentes, dans lequel le filament (20) est formé dans un matériau résistif à coefficient de température non nul.

7. Equipement électrique selon l'une des revendications précédentes, dans lequel le filament (20) serpente de façon régulière sur la surface du substrat (18).

8. Equipement électrique selon l'une des revendications précédentes, dans lequel le filament (20) est formé de deux conducteurs électriques (42, 44) séparés.

9. Equipement électrique selon la revendication 8, dans lequel les deux conducteurs électriques (42, 44) recouvrent sensiblement la totalité d'une surface utile (46) de l'écran (16), la surface utile (46) étant la plus petite surface de contour convexe de l'écran (16) entourant le filament (20).

10. Equipement électrique selon l'une quelconque des revendications 8 ou 9, dans lequel les deux conducteurs électriques (42, 44) sont disposés sur le substrat (18) de façon à limiter la surface d'une spire formée par le filament (20).

11. Equipement électrique selon l'une des revendications précédentes, dans lequel l'écran (16) forme un écran électrostatique entre les deux circuits (12, 14).

12. Equipement électrique selon l'une des revendications précédentes, dans lequel chacun des circuits (12, 14) est un enroulement (82, 84), l'équipement formant un transformateur (80).

13. Equipement électrique selon la revendication 12, dans lequel l'écran (16) est disposé parallèlement à une direction principale (88) d'un champ magnétique couplant les deux enroulements (82, 84).

## Patentansprüche

1. Elektrische Ausrüstung, Folgendes beinhaltend:
• zwei elektrisch isolierte Schaltkreise (12, 14),
• einen zwischen den beiden Schaltkreisen (12, 14) angeordneten filmförmigen Schirm (16), wobei der Schirm (16) ein Substrat (18) und einen leitfähigen Faden (20) beinhaltet, welcher auf dem Substrat (18) angeordnet ist,
• ein Modul (26), welches konfiguriert ist, um einen Strom in dem leitfähigen Faden (20) zirkulieren zu lassen und um einen Bruch des leitfähigen Fadens (20) durch Unterbrechung der Zirkulation des Stroms zu erkennen.

2. Elektrische Ausrüstung nach Anspruch 1, wobei das Modul (26) konfiguriert ist, um einen Schütz (64, 70) zu öffnen, wenn ein in dem Faden (20) strömender Strom null beträgt.

3. Elektrische Ausrüstung nach Anspruch 2, wobei der Schütz (64, 70) die Stromversorgung mindestens eines der Schaltkreise (12, 14) gewährleistet.

4. Elektrische Ausrüstung nach einem der Ansprüche 2 oder 3, wobei das Modul (26) konfiguriert ist, um den Schütz (64, 70) zu öffnen, wenn ein in dem Faden (20) zirkulierender Strom einen gegebenen Schwellenwert unterschreitet.

5. Elektrische Ausrüstung nach einem der vorhergehenden Ansprüche, wobei ein erster (12) der beiden Schaltkreise eine Vorderfläche (22) aufweist, ein zweiter (14) der beiden Schaltkreise eine Vorderfläche (24) aufweist, die beiden Vorderflächen (22, 24) einander zugewandt sind, wobei eine gemeinsame Fläche (30) definiert ist, welche dem größeren Teil gegenüber den beiden Vorderflächen (22, 24) entspricht, und wobei die Abmessungen der Schirmfläche (16) größer als diejenigen der gemeinsamen Fläche (30) sind.

6. Elektrische Ausrüstung nach einem der vorhergehenden Ansprüche, wobei der Faden (20) aus einem resistiven Material mit einem Temperaturkoeffizienten ungleich null gebildet ist.

7. Elektrische Ausrüstung nach einem der vorhergehenden Ansprüche, wobei der Faden (20) regelmäßige Schlangenlinien an der Oberfläche des Substrates (18) bildet.

8. Elektrische Ausrüstung nach einem der vorhergehenden Ansprüche, wobei der Faden (20) aus zwei getrennten elektrischen Leitern (42, 44) gebildet ist.

9. Elektrische Ausrüstung nach Anspruch 8, wobei die beiden elektrischen Leiter (42, 44) im Wesentlichen die Gesamtheit einer Nutzfläche (46) des Schirms (16) bedecken, wobei die Nutzfläche (46) die kleinste konvexe Konturfläche des Schirms (16) ist, welche den Faden umgibt (20).

10. Elektrische Ausrüstung nach einem der Ansprüche 8 oder 9, wobei die beiden elektrischen Leiter (42, 44) auf dem Substrat (18) dergestalt angeordnet sind, dass die Fläche einer durch den Faden (20) gebildeten Windung begrenzt wird.

11. Elektrische Ausrüstung nach einem der vorhergehenden Ansprüche, wobei der Schirm (16) einen elektrostatischen Schirm zwischen den beiden Schaltkreisen (12, 14) bildet.

12. Elektrische Ausrüstung nach einem der vorhergehenden Ansprüche, wobei jeder der Schaltkreise (12, 14) eine Wicklung (82, 84) ist, wobei die Ausrüstung einen Transformator (80) bildet.

13. Elektrische Ausrüstung nach Anspruch 12, wobei der Schirm (16) parallel zu einer Hauptrichtung (88) eines Magnetfeldes angeordnet ist, welches die beiden Wicklungen (82, 84) koppelt.

## Claims

1. Electrical equipment item comprising:
• two electrically insulated circuits (12, 14),
• a screen (16) in the form of a film arranged between the two circuits (12, 14), the screen (16) comprising a substrate (18) and a conductive filament (20) arranged on the substrate (18),
• a module (26) configured to circulate a current in the conductive filament (20) and to detect a breaking of the conductive filament (20) through the stopping of the circulation of the current.

2. Electrical equipment item according to claim 1, wherein the module (26) is configured to open a contactor (64, 70) if a current circulating in the filament (20) is nil.

3. Electrical equipment item according to claim 2, wherein the contactor (64, 70) ensures the electrical power supply of at least one of the circuits (12, 14).

4. Electrical equipment item according to one of claims 2 or 3, wherein the module (26) is configured to open the contactor (64, 70) if a current circulating in the filament (20) passes below a given threshold.

5. Electrical equipment item according to one of the preceding claims, wherein a first (12) of the two circuits has a front-end surface (22), a second (14) of the two circuits has a front-end surface (24), the two front-end surfaces (22, 24) facing one another, wherein a common surface (30), corresponding to the facing greater portion of the two front-end surfaces (22, 24), is defined, and wherein the dimensions of the surface of the screen (16) are greater than those of the common surface (30).

6. Electrical equipment item according to one of the preceding claims, wherein the filament (20) is formed in a resistive material with non-zero temperature coefficient.

7. Electrical equipment item according to one of the preceding claims, wherein the filament (20) winds regularly over the surface of the substrate (18).

8. Electrical equipment item according to one of the preceding claims, wherein the filament (20) is formed by two separate electrical conductors (42, 44).

9. Electrical equipment item according to claim 8, wherein the two electrical conductors (42, 44) cover substantially all of a useful surface (46) of the screen (16), the useful surface (46) being the smaller surface of convex outline of the screen (16) surrounding the filament (20).

10. Electrical equipment item according to either one of claims 8 or 9, wherein the two electrical conductors (42, 44) are arranged on the substrate (18) so as to limit the surface of a turn formed by the filament (20).

11. Electrical equipment item according to one of the preceding claims, wherein the screen (16) forms an electrostatic screen between the two circuits (12, 14).

12. Electrical equipment item according to one of the preceding claims, wherein each of the circuits (12, 14) is a winding (82, 84), the equipment item forming a transformer (80).

13. Electrical equipment item according to claim 12, wherein the screen (16) is arranged parallel to a main direction (88) of a magnetic field coupling the two windings (82, 84).
